# EUROPEAN PATENT SPECIFICATION

(11) **EP 1 993 850 B1**
(45) Date of publication and mention of the grant of the patent: **23.12.2009**
(21) Application number: 07705209.0
(22) Date of filing: 14.02.2007
(51) Int. Cl.: B41N 3/08, G03F 7/30, G03D 3/13

(54) **METHODS AND MEANS RELATING TO PHOTOPOLYMER PRINTING PLATES**
PHOTOPOLYMERE DRUCKPLATTEN BETREFFENDE VERFAHREN UND MITTEL
PROCEDES ET MOYENS SE RAPPORTANT AUX PLAQUES D'IMPRESSION PHOTOPOLYMERES

(30) Priority: 14.02.2006 GB 0602967
(43) Date of publication of application: 26.11.2008
(73) Proprietor: DANTEX GRAPHICS LTD., Bradford, West Yorkshire BD2 1EY (GB)
(72) Inventor: DANON, Richard, Leeds Yorkshire LS17 8SG (GB)
(74) Representative: Webster, Jeremy Mark
(86) International application number: PCT/GB2007/000525
(87) International publication number: WO 2007/093797

(56) References cited:
- EP-A- 0 383 314
- US-A- 4 272 000
- US-A- 6 152 618

## Description

This invention relates to methods and apparatus for processing photopolymer printing plates, such as photopolymer relief flexographic printing plates. More particularly this invention relates to processing photopolymer plates subsequent to exposure.

Photopolymer relief printing plates, such as flexographic printing plates, are manufactured using a blend of photopolymeric chemicals with rubber-like properties. They are extensively used in the printing industry for applications such as flexible packaging, envelope printing, paper and plastic sack printing, carton printing, and label printing.

Photopolymer printing plates are prepared in a variety of sizes and thicknesses, depending on the specification of the printing press. For example, when printing labels it is common to use a plate having a thickness of 1.14mm, whereas for the printing of carton boxes the plate may be required to have a thickness of 4.70 or 5.5mm or even 6.35mm.

Methods of producing the plates are well-known and are generally produced in the following manner. Initially a negative film depicting the required image is placed securely on to the face side of the photopolymer plate. The face side of the plate is then subjected to ultra violet light having a wave-length of between 250 and 500 nm. Light entering through the 'white' areas of the film hardens the polymer in these areas immediately, whilst the 'black' areas of the film reject the light, leaving the polymer surface under it to remain soft.

Methods of washing out of photopolymer plates using water are also well-known. This process is usually carried out in an in-line or a combination stacker type plate processor and it usually involves the re-circulation of a fixed volume of wash-out water though the wash-out chamber a number of times before the fluid is discarded (see US-A-5055870).

For example, a plate making system may typically operate with a fixed volume of water contained in a heated tank within the processor. To aid the wash-out process the water may contain water softening agent such as an alkaline compound, typically sodium hydroxide and/or sodium carbonate. This wash-out liquid is pumped to the wash-out section of the processor, where it is brought into contact with a wash-out brush, which is set at an optimum distance from the surface of the plate which is to be washed-out. The wash-out brush may effect a side to side and orbital movement (see WO-A-92/22014). The hot water and the brush action on the surface of the printing plate remove the soft polymer leaving behind the hardened relief image. The water in the wash-out section of the processor, having been in contact with the printing plate, returns via gravity to the holding tank ready to be pumped back again to the wash-out section as and when it is required to wash-out a further plate (see WO-A-92/22015).

The plate at this time is regarded as semi-finished and needs to be given additional treatments such as rinsing of the surface to clean off any suspended solid particles from the action of the wash-out and drying off of the water followed by irradiation with UV light to effect post-exposure and detack (see WO-A-92/22014).

We have realised that there are a number of problems associated with processing plates. For example, the wash-out process creates a high quantity of solid particles which often remain on the surface of the plate. In addition, there is usually a residue of dirty water in the machine, such as on the surfaces of the various working parts, e.g. transportation rollers. This may cause particles to become attached to the surface of the plate.

Moreover, water-washable printing plates which comprise a blend of acrylic esters with amide resins, rubber compounds, photo-initiators and plasticizers create an abundance of suspended solid particles.

In order to remove debris that has become attached to the surface of the printing plate a rinsing bar is often employed. However, when the debris is well impressed on to the surface of the plate, the gentle action of the rinsing water is insufficient to remove it and the debris is often found to be fixed to the surface of the plate. Furthermore, if any free-floating debris remains on the surface of the plate when the plate undergoes post-exposure it will be fixed onto the surface of the plate by the action of UVA light. Therefore, if all such particles are not removed from the plate surface, the particles may cause a misprint when the plate is finally placed on the printing press. An error at this juncture is extremely costly as replacing a printing plate after it has been placed on the printing press results in machine downtime until new plates are brought to the press. It is therefore very important that all debris is removed from the surface of the plate.

Another problem associated with relief printing plate manufacturing is the distance of the brush bristles from the surface of the plate. It is easily understandable that a distance, set for a plate at a thickness of 1.14mm, will not be at optimum distance when a thicker plate may be required to be processed. Inevitably, bristles will bend and, rather than having a brush action, the bristles will be stroking the surface of the thicker plate.

We have provided herein methods and apparatus which attempt to address these problems. In a general aspect, the invention provides methods and apparatus for feeding a photopolymer elastomeric printing plate, subsequent to exposure and washing out, along a path through a rinsing station by driving the plate with a roller, which roller is profiled so as to drive the plate without contacting the printing surface of the plate. A rotary brush is also provided, which brush is constructed so that on contact with the plate the rotation of the brush causes any debris on the printing surface of the plate to move away from the printing surface areas, towards at least one edge, of the plate.

According to a first aspect, there is provided a method for feeding a photopolymerised elastomeric printing plate, subsequent to exposure and washing out thereof, along a path through a rinsing station, which method comprises:
optionally providing a plate assembly comprising the plate and, supporting the plate, a carrier having a pair of opposed peripheral regions each extending laterally beyond respective opposed lateral edge regions of the plate,
providing, transversely of the path, at least one pair of driven rollers defining a nip therebetween through which the plate can pass so as to be forwarded along the path by frictional engagement of the plate or plate assembly with each of the driven rollers within the nip, at least one of which rollers is profiled so as
   (a) to allow contact of the profiled roller with the opposed lateral edge regions of the plate, or, when provided, corresponding opposed peripheral regions of the plate assembly, thereby to allow the said frictional engagement, but
   (b) to allow freedom from contact of the plate with the or each profiled roller at an interior region of the plate between the said regions in contact with the or each profiled roller, and
feeding the plate, or optionally when provided, the plate assembly, by the driven rollers along the path through the rinsing station.

In known methods for conveying a photopolymerised elastomeric printing plate through a processing station, the plate may be driven using 'nip' rollers, which may be fully clad transport rollers. Such rollers are usually provided as a pair of rollers, one above the other, and drive the plate through the space between them. The rollers are usually cylinders having a more or less constant circular cross section across their length, and thus contact the whole surface of the plate as it travels between the rollers. Any debris, for example solid particles, on the surface of the plate may become embedded in the plate by contact with the rollers.

In accordance with the above first aspect of the invention, the plate may therefore be driven through a rinsing station using at least one roller which does not have a constant circular cross section, but rather has a cross-section such as to prevent contact with the plate at least in its printing surface areas. Such a roller is referred to herein as a "profiled roller", a preferred form of which, as later described, is referred to as an "edge-roller". Any pair of rollers for driving the plate which define a nip therebetween through which the plate can pass may include one or two such profiled rollers.

Preferably at least the roller of the pair of rollers adjacent to the printing surface of the plate is a profiled roller. Such a roller is profiled so as to allow freedom from contact of the plate with the or each such roller throughout the printing area of the plate.

On the other hand, such rollers grip the plate, or plate assembly, at peripheral regions and drive the plate without the contacting an interior region of the surface of the plate. Thus, the use of a profiled roller to drive the plate through a rinsing station may reduce the amount of solid particles embedded in the plate, in particular in the printing surface of the plate. Solid particles are therefore easier to remove by rinsing and brushing.

In addition, because profiled rollers do not contact an interior region of the plate, any suspended solid particles on the surface of the plate may move over the said interior region of the plate to a position outside the rinsing station as the plate is driven into the rinsing station, and/or may move to a position inside the rinsing station as the plate is driven out of the rinsing station. In contrast, fully clad transport rollers may trap suspended solid particles within the rinsing station whilst the plate is driven into the rising station.

The plate may be driven through a rinsing station by direct contact with the profiled rollers. However, preferably, there may be provided a plate assembly comprising the plate and, supporting the plate, a carrier having a pair of opposed peripheral regions, preferably each extending laterally beyond respective opposed lateral edge regions of the plate. In such a plate assembly the plate is supported on the carrier, for example in piggy-back fashion. Especially if the plate is flexible, and/or cannot support its own weight, the use of a carrier is preferably appropriate. The carrier may therefore be a carrier sheet, which is a rigid sheet for supporting the plate, and which may maintain the plate in a substantially flat position. Such carrier sheets are well known in the art, and for example, may be made from steel sheeting on to which a layer suitable for contacting the plate is placed in a manner such that the plate is secured thereto. This plate-contacting layer may, for example, be magnetic for use with steel backed plates, or may be a sticky foil surface for use with plastic backed plates.

The face of the carrier that supports the plate may be larger than the plate, such that at least a pair of opposed peripheral regions each extend laterally beyond respective opposed lateral edge regions of the plate. Preferably, a pair of opposed edges of the carrier extend beyond the corresponding edges of the plate. Preferably the distance between a pair of such opposed edges of the carrier is larger than the distance between the corresponding opposed edges of the plate. Thus, an edge-roller may drive the plate through the rinsing station by contacting one or both of a pair of opposed peripheral regions of the carrier and/or opposed lateral edge regions of the plate.

In a preferred drive system for feeding the plate through the rinsing station by passage into the nip of a pair of driven rollers, at least the roller adjacent the printing surface of the plate and preferably each such roller providing the nip is an edge-roller. Thus, the edge-roller may drive the plate through the rinsing station by contacting opposed peripheral regions of the plate such that the edge-roller contacts the carrier and/or the plate at one or each of the opposed peripheral regions. Preferably the edge-roller drives the plate through the rinsing station without contacting the plate.

A carrier may not be necessary for use with all plates suitable for use with the invention, for example if the plate is rigid the plate may be driven through a processing apparatus, including the rinsing station, without a carrier sheet.

Preferably each roller has a longitudinal axis, and each profiled roller comprises a middle portion located between each of a pair of end portions on the longitudinal axis such that each end portion contacts the plate and/or carrier and the middle portion does not contact the plate. Preferably the pair of end portions, defining respective contact regions, one at each of opposed longitudinal ends of the profiled roller, have a radial cross-section larger than that of any part of the middle portion axially between the contact regions and therefore are free from contact with the printing plate. Preferably each end portion is of a substantially circular radial cross-section. More preferably, the respective opposed longitudinal end portions of the roller have the same diameter. Hereinafter such a roller will be referred to as an "edge-roller".

Thus, such a roller is profiled so that it contacts the plate and/or carrier in at least two positions. This arrangement allows the edge-roller to apply a symmetrical force to the plate and/or carrier in the direction of travel, thereby allowing smooth movement of the plate and/or carrier, and also allows the edge-roller to avoid contacting the printing surface of the plate.

The plate for use with the invention may be a photopolymer relief printing or moulding plate, a pre-sensitised aluminium printing plate, or any other type of plate which needs to be washed out post-exposure to remove unexposed areas. The plate may be either water washable, in which case the washout fluid and/or rinsing fluid is water or a suitable aqueous solution, or organic solvent washable, in which case the washout fluid comprises one or more appropriate organic solvents. Preferably, the plate is water washable.

Preferably the plate travels through the processor on a flat bed, for example a table top, above which is the brush head which can be raised or lowered according to the entering plate thickness, thus offering optimum bristle distance and wash-out action to the surface of the plate.

More preferably the flat bed provides a surface for contacting the plate which allows the plate to move easily over the flat bed. Still more preferably, the flat bed has a lateral width that is narrower than the space between respective opposed longitudinal end portions of the edge-roller.

In a second aspect, there is provided apparatus for feeding a photopolymerised elastomeric printing plate, subsequent to exposure and washing out thereof, along a path through a rinsing station, which apparatus comprises:
a rinsing station for rinsing the plate,
at least one pair of drivable rollers defining a nip therebetween through which the plate can pass to allow the plate to be forwarded along the path by frictional engagement of the plate, or of a plate assembly including the plate, with each of the rollers within the nip,
wherein the plate assembly, when provided, comprises the plate and, supporting the plate, a carrier having a pair of opposed peripheral regions, each extending laterally beyond respective opposed lateral edge regions of the plate,
and wherein at least one of which rollers is profiled so as
   (a) to allow contact of the profiled roller with the opposed lateral edge regions of the plate, or, when provided, corresponding opposed peripheral regions of the plate assembly, thereby to allow the said frictional engagement, but
   (b) to allow freedom from contact of the plate with the or each profiled roller at an interior region of the plate between the said regions in contact with the or each profiled roller.

The apparatus of the second aspect is preferably provided to enable any method of the first aspect to be performed.

In a third aspect, there is provided a method for rinsing a photopolymerised elastomeric printing plate, subsequent to exposure and washing out thereof, to provide a printing surface thereof, while travelling along a path through a rinsing station, which method comprises:
contacting the plate with a rotating brush, which brush has a longitudinal axis extending transversely across the plate, and which brush, on rotation about its longitudinal axis, sweeps a substantially cylindrical path of rotation,
and wherein the brush is so constructed that on contact thereof with the plate, the rotation of the brush causes any debris on the printing surface of the plate to move away from the printing surface towards a peripheral region of the plate.

Preferably rotation of the brush causes any debris on the plate, for example solid particles, to move, from an interior region of the plate towards respective edges of the plate, which edges run at least substantially in, more preferably in, the direction of travel of the plate. Preferably, rotation of the brush pushes debris on the surface of the plate laterally in a direction substantially perpendicular to the direction of travel of the plate. Providing such a brush to contact the plate as the plate is driven through a rinsing station allows solid particles to be more effectively removed from the surface of the plate, especially the printing surface of the plate, thereby providing a more accurate printing surface. The brush may be positioned within a rinsing station to contact the plate prior to contacting the plate with rinsing fluid, and/or after contacting the plate with rinsing fluid, and/or while the plate is being contacted with rinsing fluid.

Preferably the brush comprises brushing means, which brushing means are provided in a spiral arrangement. Preferably the axis of the spiral arrangement is substantially coaxial with the longitudinal axis of the brush. Providing the means for brushing in a spiral arrangement allows the rotational motion of the brush to push solid particles to a lateral edge of the plate, i.e. an edge running substantially in the direction of travel of the plate.

Preferably the brushing means are provided on the brush as two opposing spiral arrangements; for example, each spiral arrangement has an opposing screw thread. Preferably, as viewed from either longitudinal end of the brush, substantially half of the brushing means along the length of the brush is provided by a spiral arrangement having one screw thread, and substantially half the brushing means is provided by a spiral arrangement having the opposite screw thread, for example, such that one screw thread contacts approximately one half of the plate, and the opposing thread contacts the other half of the plate. This allows the rotational motion of the brush to push solid particles to both edges of the plate running in the direction of travel at the same time. When, for each spiral, the hand, as viewed from a longitudinal end of the brush adjacent to the spiral, runs in the same rotational direction as that of the brush, then the rotational motion of the brush pushes the solid particles towards the respective edges of the plate.

Suitable brushing means will be readily apparent to the skilled person. For example, the brushing means may be bristles and/or strips providing one or more edges. The bristles and/or strips may be embedded in a support and/or may be free-standing; they may be flexible and/or rigid. Preferably the brushing means are selected such that no damage to the printing surface occurs upon contact.,

In a preferred method of rinsing the plate, prior to brushing with the rotating (preferably double spiral) brush, the plate is fed under a barrier brush rotating in the same direction as that of the direction of travel of the plate. As the plate is forwarded under the barrier brush, the plate and barrier brush simultaneously cooperate with one another to provide a barrier preventing any substantial escape of rinsing fluid backwardly out of the rinsing station.

The third aspect is preferably used in combination with the first aspect.

In fourth aspect, there is provided apparatus for rinsing a photopolymerised elastomeric printing plate, subsequent to exposure and washing out thereof, while travelling along a path through a rinsing station, which apparatus comprises:
a rotary brush, which brush has a longitudinal axis extending transversely across the plate, and which brush on rotation about its longitudinal axis sweeps a substantially cylindrical path of rotation,
and wherein the brush is so constructed that on contact thereof with the plate, the rotation of the brush causes any debris on the printing surface of the plate to move away from the printing surface towards a peripheral region of the plate.

Preferably, as mentioned above, the apparatus additionally comprises a barrier brush located in advance of the rotary (preferably double spiral) brush. More preferably, the apparatus further comprises means for supply of rinsing fluid to the plate in the vicinity of the barrier brush, for example, at least one spray bar.

The apparatus of the fourth aspect is preferably provided to enable any method of the third aspect to be performed.

In a fifth aspect, there is provided a method for feeding a photopolymerised elastomeric printing plate, subsequent to exposure and washing out thereof, to provide a printing surface thereof, along a path through a rinsing station, which method comprises:
inclining the plate, for example by providing an inclined support for the plate after contacting the plate with rinsing fluid, such that rinsing fluid on the printing surface of the plate, and/or on any inclined support for the plate, is allowed by gravity to run off the printing surface of the plate and/or inclined support in a direction towards the rinsing station.

Allowing the plate to incline as the plate progresses through the rinsing station enables excess rinsing fluid on the surface of the plate, and/or any inclined support for the plate to be directed to a holding tank, taking with it any suspended solid particles. This allows solid particles to be more effectively removed from the surface of the plate, especially the printing surface of the plate, thereby providing a more accurate printing surface.

Preferably the incline is in a direction such that a leading edge of the plate is raised above a trailing edge of the plate. Inclining the plate and/or any support for the plate upwards encourages rinsing fluid in contact with the plate to drain off the rear side of the plate, and back along the path of the plate into the rinsing station and/or into a holding tank, thereby reducing the possibility of rinsing fluid entering any subsequent process station. This is particularly applicable to in-line processing arrangements in which a plate follows a path through a number of different processing stations. Often, a rinsing station is followed by detack and post exposure processing station(s), which includes electrical components, such as UV lamps. Therefore it is particularly desirable to avoid rinsing fluid entering such stations. Preferably the angle of inclination of the plate and/or any support for the plate is 1-10°, or even 1-15° from horizontal, preferably 1-6°, most preferably 2-4° from horizontal.

The fifth aspect is preferably used in combination with the third and/or the first aspect.

In a sixth aspect, there is provided apparatus for feeding a photopolymerised elastomeric printing plate, subsequent to exposure and washing out thereof, along a path through a rinsing station, which apparatus comprises:
means for inclining the plate, for example by providing an inclined support for the plate, after contacting the plate with rinsing fluid, such that any rinsing fluid on the printing surface of the plate and/or inclined support for the plate is allowed by gravity to run off the printing surface and/or inclined support in a direction towards the rinsing station.

The apparatus of the sixth aspect is preferably provided to enable any method of the fifth aspect to be performed.

In a method according to the fifth, the third, and/or the first aspect, the method preferably comprises any one or more of the following steps:
a. Feeding the plate into the rinsing station with a pair of driven rollers. The pair of driven rollers preferably includes at least one edge-roller.
b. Dispersing any wash-out fluid on the plate with an air blower before contacting the plate with rinsing fluid. Preferably, the air blower exerts an air pressure from 50mmAq to 1000mmAq directed at the printing surface of the plate. Preferably the air blower directs air onto the plate at 40°-50°, especially 45°, to the direction of travel of the plate. This provides an initial drying step for the plate and also aids removal of solid particles, e.g. debris lodged within the fine crevices of an intricate design. The air blower may also act as an air knife, thereby creating a barrier to the forward flow of debris-containing wash-out fluid.
c. Brushing the plate before a subsequent rinsing operation. This aids removal of solid particles that may be lodged in small crevices of an intricate design on the printing surface of the plate to be loosened prior to rinsing. The brush is preferably rotated in the same direction as the direction of travel of a plate passing under it. Thus, as previously described above, the plate and brush may together serve as barrier preventing any substantial escape of rinsing fluid backwardly out of the rinsing station.
d. Contacting the plate with rinsing fluid. Preferably the rinsing fluid is dispensed on to the printing surface of the plate by spray bars.
e. Brushing the plate after contacting the plate with rinsing fluid. Preferably the brush includes brushing means arranged in a spiral arrangement as described herein.
f. Feeding the plate out of the rinsing station with a pair of driven rollers. The pair of driven rollers preferably includes at least one edge-roller. The same pair of rollers may feed the plate into the rinsing station and out of the rinsing station. Alternatively, separate pairs of rollers may feed the plate into the rinsing station and out of the rinsing station. The plate may be fed through the rinsing station by any number of pairs of rollers. Preferably at least one roller of each pair of rollers is an edge-roller.
g. Subjecting the surface of the plate to a jet of warm high pressure air from a hot-air blower. The hot air serves to dry the plate and disperse any remaining fluid on the plate, thereby acting as an air knife or barrier to stop any rinsing fluid, for example water, from entering the electrical section of the processor. The air blower directs air onto the plate at 40°-50°, especially 45°, to the direction of travel of the plate. Preferably the air is at a pressure of 50mmAq to 1000mmAq. The preferred air temperature is 50-65°C, especially 60°C.

Thus, in a seventh aspect of the invention there is provided a method for processing a pre-exposed photopolymerised elastomeric printing plate, having washed out the plate subsequent to exposure thereof, which method comprises the steps of:
(a) rinsing the plate in a rinsing station; and
(b) subjecting the plate to post-exposure and detack in a post-exposure station;
wherein the surface of the plate is subjected to a first jet of air before step (a) and a second jet of air after step (a) but before step (b), wherein the jet of air is directed onto the surface of the plate, and wherein the first jet of air acts as a barrier between the wash-out station and the printing station to prevent ingress of debris-containing wash-out water and the second jet of air acts a barrier between the rinsing station and the post-exposure station to substantially prevent rinsing fluid entering the post-exposure station. The post-exposure station is normally an electrical station. In this case the jet of air avoids rinsing fluid coming into contact with electrical components.

The jets of air are preferably directed onto the plate in a direction against the direction of travel of the plate, such that the first jet of air is not directed into the rinsing station and the second jet of air is not directed into the post-exposure station. Preferably, the jets of air are directed onto the surface of the plate at 40-50°, especially 45°, to the direction of travel of the plate. This aids removal of debris lodged within the fine crevices of an intricate design. Preferably, each jet of air is at set at a pressure of 50mmAq to 1000mmAq.

Preferably, in the post-exposure station UV light contacts the plate, which UV light passes through a quartz glass panel before contacting the plate, and which quartz glass panel is located in the post-exposure station. Quartz glass is more efficient at transferring UV light than ordinary glass. Thus, using a quartz glass panel will allow a greater amount of UV light to contact the plate.

Preferably, the quartz glass panel has a depth of 5-10mm, especially 6mm, in the direction of travel of the UV light towards the plate. We have found that quartz glass panels of this thickness are safer to touch.

In apparatus according to the sixth, fourth and/or second aspect, the apparatus preferably comprises any one or more of the following:
a. A pair of driven rollers for feeding the plate into the rinsing station.
b. An air blower for dispersing any wash-out fluid on the plate with an air blower before contacting the plate with rinsing fluid. Preferably, the air blower is capable of exerting an air pressure from 50mmAq to 1000mmAq directed at the printing surface of the plate. Preferably, the air blower directs air onto the plate at 40-40°, especially 45°, to the direction of travel of the plate. This provides an initial drying step for the plate and also aids removal of solid particles, e.g. debris lodged within the fine crevices of an intricate design. The air blower may also act as an air knife, thereby creating a barrier to the forward flow of debris-containing wash-out fluid.
c. A rotary (barrier) brush for brushing the plate before a subsequent rinsing operation. The rotary brush and printing plate passing underneath it cooperate together to provide a barrier preventing any significant escape of rinsing fluid backwardly out of the rinsing station, past the brush. At the same time, the rotary brush allows gentle washing to loosen any debris on the plate prior to the subsequent rinsing.
d. Spray bars for contacting the plate with rinsing fluid.
e. A rotary brush for brushing the plate after contacting the plate with rinsing fluid.
f. A pair of driven rollers for feeding the plate out of the rinsing station.
g. A hot-air blower, capable of subjecting the surface of the plate to a jet of high pressure warm air. The hot air is for drying the plate and dispersing any remaining fluid on the plate, thereby acting as an air knife or barrier to stop any rinsing fluid, for example water, from entering the electrical section of the processor. Preferably the air is at a pressure of 50mmAq to 1000mmAq. Preferably, the hot-air blower directs air onto the plate at 40-50°, especially 45°, to the direction of travel of the plate. Preferably, the air temperature is 50-65°C, especially 60°C.

Thus, according to an eighth aspect, the invention also provides apparatus for processing a pre-exposed photopolymerised elastomeric printing plate, having washed out the plate in a wash-out station subsequent to exposure thereof, comprising
(a) a rinsing station for rinsing the plate;
(b) a post-exposure station for subjecting the plate to post exposure and detack;
(c) a first air blower located between the wash out station and the rinsing station; and
(d) a second air blower located between the rinsing station and the post-exposure station, wherein each air blower (c) and (d) is capable of blowing a jet of air onto the surface of the plate, the first air blower thereby acting as a barrier to prevent ingress of debris-containing wash-out water into the rinsing station and the second air blower thereby acting as a barrier to substantially prevent rinsing fluid entering the post-exposure station. The post-exposure station is normally an electrical station. In this case the jet of air avoids rinsing fluid coming into contact with electrical components.

The jets of air are preferably directed onto the plate in a direction against the direction of travel of the plate, such that the first jet of air is not directed into the rinsing station and the second jet of air is not directed into the post-exposure station. Preferably, the jets of air are directed onto the surface of the plate at 40-50°, especially 45°, to the direction of travel of the plate. This aids removal of debris lodged within the fine crevices of an intricate design. Preferably, each air blower is capable of providing the jet of air at a pressure of 50mmAq to 1000mmAq.

Preferably, any of apparatus (a) to (g) above allows the corresponding method of (a) to (g) above to be performed.

Preferably, the post-exposure station comprises:
(a) a UV light source
(b) a quartz glass panel; and
(c) means for locating a plate in the post-exposure station;
wherein the quartz glass panel is positioned between the UV light source and the means for locating a plate in the post-exposure station, such that UV light passes through the quartz glass panel before contacting a plate located in the post-exposure station.

Preferably, the quartz glass panel has a depth of 5-10mm, especially 6mm, in the direction of travel of the UV light towards a plate located in the post-exposure station.

In a ninth aspect, there is provided a method for washing out a photopolymerised elastomeric printing plate, subsequent to exposure thereof, comprising the step of subjecting the plate to a flow of wash-out fluid and allowing the washout fluid to flow through a filtration unit after its contact with the plate, wherein the filtration unit houses a wire sieve such that wash-out fluid flowing through the filtration unit flows through the sieve.

As subsequent plates are processed, the quality of wash-out fluid, for example water, in the holding tank deteriorates. Its viscosity increases due to the high quantity of suspended solid waste particles entering the tank causing the wash-out efficiency to be reduced.

Although filtration is a method commonly used to clean waste wash-out fluid, in order to efficiently filter suspended solid particles from the waste wash-out fluid a precipitation tank is used, which tends to become clogged and cause an over-flow of wash-out fluid. Inefficient filtration increases the likelihood of debris, such as solid particles from becoming attached to the plate, thereby causing misprints. We have found that polymer particles effectively adhere to a wire mesh, i.e. a wire sieve, presumably because the polymer particles are sticky. Waste wash-out fluid is preferably, collected from the wash-out station by a holding tank, which holding tank is preferably in fluid communication with the filtration unit.

Preferably the filtration unit houses at least two wire sieves such that wash fluid flowing through the filtration unit flows through both sieves, wherein one sieve has a larger mesh grading, i.e. pore size, than the other sieve, and the wash fluid flows through the sieve having a larger pore size before flowing through the other sieve. This allows an economical manner of debris collection, where solid waste can be trapped and disposed of as solid material. Preferably the filtration unit comprises three sieves, preferably stainless steel wire sieves, more preferably having a mesh grading, i.e. pore size, of 200 microns, 100 microns, and 70 microns respectively. Preferably each sieve is housed in a filter cartridge, preferably a re-usable filter cartridge. Preferably the last filter is a charcoal filter, enabling clear wash-out fluid to be discharged from the filtration unit. Preferably wash-out fluid discharged from the filtration unit is re-circulated to the processor.

Preferably the filtration unit comprises means for sensing the pressure of the wash fluid, for example a pressure valve, preferably mounted at a position before the wash fluid flows through a sieve housed in the filtration unit. When the pressure reaches a predetermined level, for example because of a build-up of solid waste within the filtration unit and/or saturation of a filter, the means for sensing the pressure provides an alert to the operator to change a filter cartridge. The means for sensing the pressure preferably comprises an indicator to alert the operator to change any specific filter cartridge within the filtration unit.

Waste rinsing fluid may also be collected in a holding tank and filtered by a filtration unit as described above.

The ninth aspect is preferably used in combination with the seventh, fifth, the third and/or the first aspect.

In a tenth aspect, there is provided apparatus for washing out a photopolymerised elastomeric printing plate, subsequent to exposure thereof, comprising a source of wash fluid, means for supplying fluid from the source of wash-out fluid to a plate positioned in the apparatus, means for allowing fluid to flow to a filtration unit after contact with the plate, and a filtration unit, wherein the filtration unit houses a wire sieve such that wash-out fluid flowing through the filtration unit flows through the sieve.

The apparatus of the tenth aspect is preferably provided to enable any method of the ninth aspect to be performed.

In an eleventh aspect, there is provided a method for processing a pre-exposed photopolymerised elastomeric printing plate comprising the step of washing out the plate according to the ninth aspect, and/or comprising the step of rinsing the plate according to the fifth, the third and/or first aspect and/or directing a jet of air onto the surface of the plate, as in the seventh aspect.

The method for processing a photopolymerised elastomeric printing plate preferably additionally includes any one or more of the following steps:
a. Providing a combined water spray and brush action immediately before the plate is washed out by brush action.

When first entering an in-line plate processor, the printing plate is driven forward by the action of front drive rollers, which push the printing plate into the wash-out section where the combined action of the wash-out fluid and the brush start the removal of the unexposed parts of the printing plate. As the plate entering the brush-section is effectively dry at this stage, the removal of the unexposed polymer is carried out in a sudden and harsh manner, potentially damaging the image areas.

Providing a combined water spray and brush action immediately before the plate is washed out by brush action softens the surface of the plate prior to washing-out and thereby allows the wash-out brush to be more effective. It also allows an initial removal of unexposed areas of plate.
b. Providing a source of clean and/or filtered wash-out fluid, which wash-out fluid is preferably water.
c. Directing the said wash-out fluid continuously through a spray bar situated in the vicinity of (for example amongst) downwardly directed bristles of a wash-out brush head and adapted to direct the wash-out fluid downwardly along the bristles to the plate, whilst the plate is being brushed.
d. Allowing the wash-out fluid to flow to waste, or to a cleaning and/or filtering station for immediate recirculation. Preferably, the cleaning and/or filtering station is off-board; it does not form part of an in-line system.
e. Simultaneously subjecting the plate to post-exposure and detack. Post-exposure is preferably performed by irradiating the plate with UVA tubes providing radiation at a wavelength of 300-400nm. This provides a final hardening step for the photopolymer and ensures a completely finished plate. Detack is preferably performed by irradiating the plate with UVC tubes providing radiation at a wavelength of 200-250 nm. This eliminates the surface tack of the plate and provides an inert printing surface.

Preferably, in the post-exposure station, UV light contacts the plate, which UV light passes through a quartz glass panel before contacting the plate, and which quartz glass panel is located in the post-exposure station. Preferably, the quartz glass panel has a depth of 5-10mm, especially 6mm, in the direction of travel of the UV light towards the plate.

In a twelfth aspect, there is provided apparatus for processing a pre-exposed photopolymerised elastomeric printing plate, which apparatus comprises apparatus for washing out a plate according to the tenth aspect, and/or comprises apparatus for rinsing a plate according to the sixth, fourth or second aspect and/or apparatus for directing a jet of air onto the surface of the plate, as in the eighth aspect.

The apparatus of the twelfth aspect is preferably provided to enable any method of the eleventh aspect to be performed.

An apparatus suitable for carrying out the method of the eleventh aspect comprises:
a. a combined brush and water spray adapted to soften the plate prior to a wash out brushing operation;
b. a source of clean and/or filtered wash-out fluid;
c. a wash-out brush having a wash-out brush head with downwardly directed bristles; and/or
d. a spray bar situated in the vicinity of (for example amongst) downwardly directed bristles, and adapted to direct the said wash-out fluid downwardly along the bristles to the plate and/or
e. an air blower between the rinsing and post-exposure stations.

In a thirteenth aspect of the invention there is provided a method for processing a pre-exposed photopolymerised elastomeric printing plate, having washed out the plate subsequent to exposure thereof, which method comprises the step of subjecting the plate to post-exposure and detack in a post-exposure station,
wherein in the post-exposure station UV light contacts the plate, which UV light passes through a quartz glass panel before contacting the plate, and which quartz glass panel is located in the post-exposure station.

Preferably, the quartz glass panel has a depth of 5-10mm, especially 6mm, in the direction of travel of the UV light towards the plate.

In a fourteenth aspect of the invention there is provided apparatus for processing a pre-exposed photopolymerised elastomeric printing plate, having washed out the plate in a wash-out station subsequent to exposure thereof, comprising a post-exposure station for subjecting the plate to post exposure and detack, wherein the post-exposure station comprises:
(a) a UV light source
(b) a quartz glass panel; and
(c) means for locating a plate in the post-exposure station;
wherein the quartz glass panel is positioned between the UV light source and the means for locating a plate in the post-exposure station, such that UV light passes through the quartz glass panel before contacting a plate located in the post-exposure station.

Preferably, the quartz glass panel has a depth of 5-10mm, especially 6mm, in the direction of travel of the UV light towards a plate located in the post-exposure station.

The inventors have also investigated alternative methods of transporting photopolymerised elastomeric printing plates through in-line plate processors. A known method of transportation is by use of chain driven pin-bar system. In this method, a hole is punched at the very edge of the plate and the plate is placed onto a pin-bar wherein the pins will correspond correctly to the previously punched hole. The pin-bar is then locked in to position on the chain drive, which is in continuous motion on the right and left hand side down the length of the machine. The pin-bar is thus pulled into the processor and the plate follows the path of the pin-bar. However, since the plate can only be top and tail end secured, the edges of the plate are left loose and are thus susceptible to be caught by the orbital action of the wash-out brush, and may become damaged. In addition, transportation by carrier sheet may be difficult for the operator to handle above a certain size and/or weight.

Accordingly, in a fifteenth aspect, there is provided a method for processing a pre-exposed photopolymerised elastomeric printing plate comprising the step of feeding the plate along a path through a plate processor wherein the plate is mounted on a transport belt, which belt drives the plate along the path, and which belt is arranged in a continuous loop, wherein the belt has a surface which secures the plate in a stationary manner relative to the belt as the plate is fed along the path, and wherein the plate is removed from the belt after the plate has been processed by a device capable of lifting the plate away from the belt.

Transporting a plate through a plate processor using a continuous belt allows larger and/or heavier plates to be more easily processed, for example, plates having a dimension of 900mm x 1000mm or larger, and reduces any damaging effect of brush action on the sides of the plate.

The plate processor may comprise all the stations required to process a plate, for example, one or more of an entry station, a wash-out station, a rinsing station, a light-finishing station and a final drying station. Thus, the method may include dispersing any wash-out fluid on the plate with an air blower before contacting the plate with rinsing fluid as described above, brushing the plate with a barrier brush before a subsequent rinsing operation after washing out the plate as described above, and/or contacting the plate in the rinsing station with a rotating brush for removing debris from the surface of the printing plate as described in the third aspect

The plate may be secured to the belt in a stationary manner relative to the belt by providing on the belt surface a material that causes the plate to adhere to the belt, having a tacky substance, for example being manufactured from a pressure sensitive adhesive plastics or rubber sheeting having a naturally sticky surface. The belt may comprise more than one layer; for example, it may comprise a plate carrying layer, and a flexible backing material, which backing material does not contact the plate.

The device capable of lifting the plate away from the belt preferably has a profile shaped like a knife or a wedge which is insertable between the plate and the belt. The device may be inserted between the plate and the belt by the forward motion of the plate, mounted on the belt, towards the device.

The fifteenth aspect is preferably used in combination with the thirteenth, eleventh, ninth, the seventh, the fifth, and/or the third aspect.

In a sixteenth aspect, there is provided apparatus for processing a pre-exposed photopolymerised elastomeric printing plate, which apparatus comprises:
a plate processor;
a transport belt for supporting the plate and for driving the plate along a path through the plate processor, which belt is arranged in a continuous loop, and wherein the surface of the belt comprises means for securing the plate in a stationary manner relative to the belt as the plate is fed along the path, and
a device for removing the plate from the belt after the plate has been processed, which device is capable of lifting the plate away from the belt.

The device for removing the plate from the belt after processing is preferably a knife, co-operable with a plate coming towards it, to lift the plate off the belt.

The apparatus may additionally include an air blower for dispersing any wash-out fluid on the plate before contacting the plate with rinsing fluid as described above, a rotary barrier brush for brushing the plate before a subsequent rinsing operation after washing out as described above, and/or a rotary brush for moving the debris away from the printing surface of the plate, as described in the fourth aspect.

The apparatus of the sixteenth aspect is preferably provided to enable any method of the fifteenth aspect to be performed.

Embodiments of the invention will now be illustrated by way of example, with reference to the accompanying drawings, in which:
Figure 1 shows schematically a plan view of an in-line photopolymer printing plate processor, including a filtration unit for filtering wash-out fluid. Note that the filtration system is located below the apparatus but is shown to the side of the apparatus for clarity.
Figure 2 shows schematically a side view of the in-line photopolymer printing plate processor of Figure 1.
Figure 3 shows schematically a filtration unit.
Figure 4 shows a schematically a plan view of a section of an in-line photopolymer printing plate processor, showing in particular the spiral pattern of the double spiral brush.
Figure 5 shows schematically a side view of the section of the in-line photopolymer printing plate processor shown in Figure 4.
Figure 6 shows schematically an in-line photopolymer printing plate processor that includes a belt transportation system.

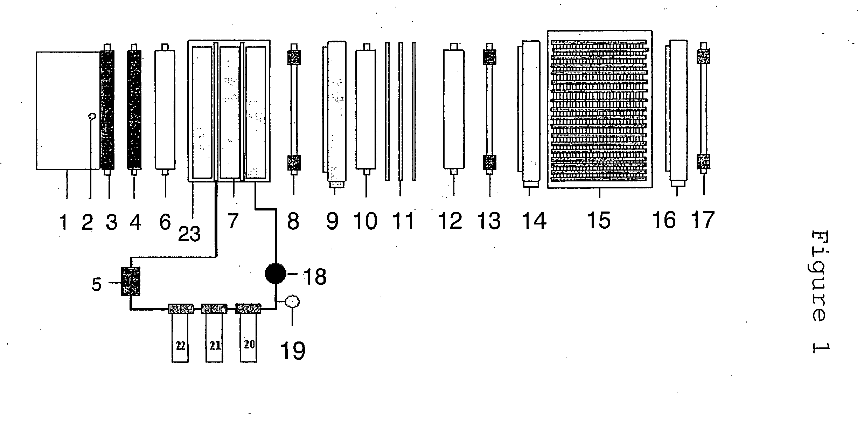

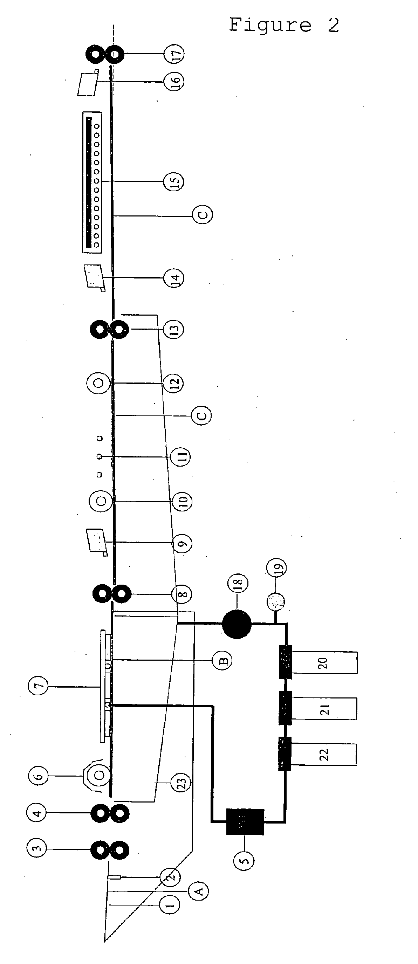

Referring to Figures 1 and 2, an in-line processor for processing a photopolymer printing plate houses the following components which are arranged in a linear sequential fashion: an in-feed table (1) for receiving the plate; a sensor (2), mounted near the processor end of the in-feed table, for detecting the presence of a plate on the in-feed table; a pair of dry-feed rollers (3); a pair of in-feed rollers (4) for feeding the plate from the in-feed table into the processor; a pre-wet brush roller and spray bar (6), which are housed below a 'C' section cover (see Figure 2) for wetting and softening the plate prior to washing-out unexposed polymer; a rotary brush or paddle brush having a brush-head (7), which may move from side to side and/or in an orbital fashion, for washing-out unexposed polymer; a pair of edge-rollers (8), each of which has a pair of axial end portions of larger diameter than the portion between the two end portions (see Figure 2), for transporting the plate forwards from the brush head through the processor; a cool air blower (9) for dispersing any wash-out fluid on the plate; a barrier brush (10) for brushing away debris on the surface of the plate and preventing backward escape of rinsing fluid from the rinsing station; spray bars (11) for dispensing rinsing fluid onto the plate; a double spiral brush (12), for brushing away debris laterally away from the surface of the plate; a pair of edge rollers (13) for transporting the plate forwards; a hot-air blower (14) blowing air at 60°C for drying the plate and dispersing any remaining fluid on the plate, acting as an air knife or barrier to stop any rinsing fluid, for example water, from entering the electrical section of the processor; a post-exposure and detack tray (15) which houses UV lamps; a final hot air blower (16), working at a temperature of between 40-60°C, for final drying of the plate in case there should be any moisture left on the surface of the plate; and a pair of discharge rollers (17) for transporting the plate out of the processor. The in-line processor also includes a fixed table top (A,B,C) for supporting the plate as it travels through the processor.

The processor also houses a holding tank (23), for retaining wash-out fluid and rinse fluid, which is connected by fluid flow tubing to a filtration unit, which in turn is connected by fluid flow tubing to the region of the processor housing the brush head (7). The filtration unit houses a filtration pump (18), a pressure indicator (19), and filtration cartridge holders (20, 21, and 22). The filtration cartridges house wire mesh filters having a grading of 200 microns, 100 microns, and 70 microns respectively. A water heater box (5), for providing instantaneous hot water, is connected to the fluid flow tubing between the filtration unit and the region of the processor housing the brush head (7).

The table top section located in front of the dry-feed rollers (3) is downwardly inclined by about 2° (A), the table top section located between in-feed rollers (4) and edge-rollers (8) is about horizontal (B), and the table top section located between edge-roller 8 and discharge rollers (17) is upwardly inclined by about 2° (C). The downward and upward inclines direct any fluid on the table top into the holding tank (23).

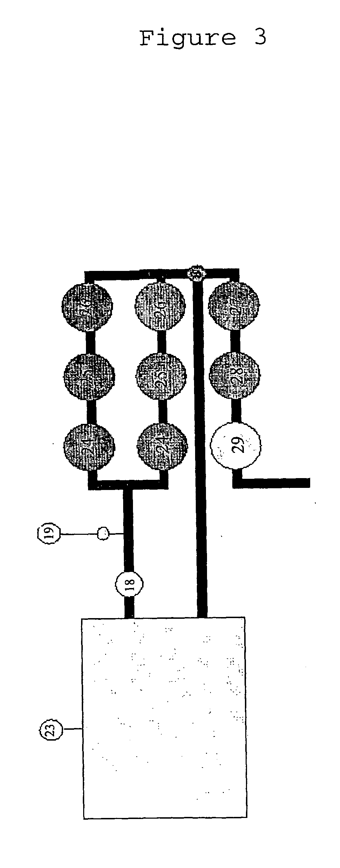

Referring to Figure 3, an alternative filtration unit for use with the plate processor of figures 1 and 2 comprises nine filter cartridges. Fluid flow tubing, connected to the holding tank, forks to connect two sets of three filter cartridges in parallel. Each set of three cartridge filters includes a 200 micron filter (24), a 100 micron filter (25), and a 70 micron filter (26). The fluid flow tubing exiting from each 70 micron filter merges together and is further connected to a 10 micron filter (27) and a 10 micron carbon filter (28) and a charcoal filter (29). A three-way valve (30) is housed in the fluid flow tubing after the tubing exiting from the 70 micron filters merges. The three-way valve is also connected directly to the holding tank by fluid flow tubing.

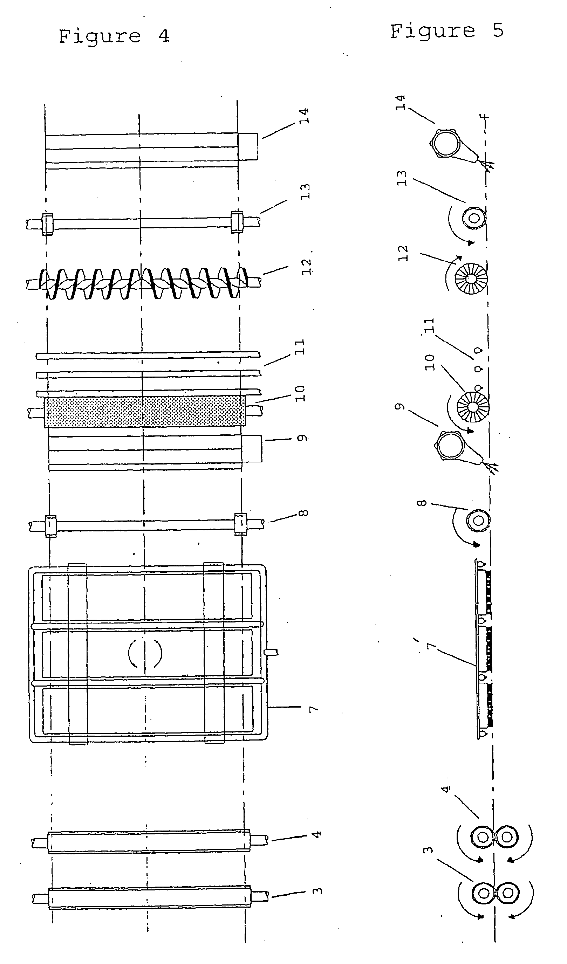

Referring to Figures 4 and 5, the double spiral brush (12) includes a cylinder, on which is mounted two opposing spiral edges at opposite ends of the cylinder such that the spiral edges meet approximately at the middle of the longitudinal axis of the cylinder. Each spiral edge has an opposite screw thread such that each screw thread is clockwise when each spiral edge is viewed along the longitudinal axis from either of the respective ends of the cylinder. Clockwise rotation of the brush causes debris on the surface of the plate to move to the respective lateral edge of the plate.

In operation, plate processing begins when a carrier sheet, on to which a printing plate is attached is brought into contact with the sensor (2) positioned on the in-feed table (1) of the processor. This action activates the machine and the dry-feed and in-feed rollers (3 & 4) begin to drive the carrier sheet forward. The instantaneous water heater (5) is also activated, which begins to deliver re-circulated hot water to the pre-wet spray bar and brush roller (6), which is housed in a 'C' section. This begins the initial action of the softening of the unexposed polymer before transferring the printing plate to under the downward facing brush head (7) to remove unexposed polymer. The carrier sheet travels over a fixed table top (A,B,C), which is located under the brush head. This table gives solid support to the carrier sheet and permits the correct pressure to be applied by the brush head on to the surface of the printing plate to enable the removal of the soft polymer areas. The instantaneous wash-out water heater eliminates the use of a wash-out water storage tank, which requires continuously to be heated to be able to maintain it at optimum working temperature. The use of an instantaneous water heater therefore reduces energy consumption, and reduces any delay in the initial start up of the process which would otherwise be caused by waiting for a fixed volume of water to be heated. In addition, a high proportion of energy is wasted in the continuous heating of wash-out water on the holding tank in order to maintain the operating temperature (i.e. to combat natural heat loss) whilst the processor is in stand-by mode. Stand-by mode is typically utilised for as much as 75% of a working shift when processing a plurality of plates in a normal daily production cycle.

The wash-out water may contain surfactants and/or detergents to stop coagulation or precipitation of free floating solid particles. In addition, chemicals such as sodium hydroxide, sodium carbonate, and or trisodium phosphate may be added to reduce precipitation.

Immediately after the brush-head (7), the edge-roller (8) drives the carrier sheet forward without touching the surface of the printing plate. This ensures a very efficient transport of the plate and if there should be any debris on the surface of the printing plate at this stage, it is free floating and not embedded into the surface. As the plate is driven through the processor it travels over a fixed table top (A,B,C) which supports the plate in the processor.

As the printing plate is driven forward it is subjected to a jet of high pressure air from the air-blower (9), which can be set from 50 mmAq to 1000 mmAq, directed at the surface of the plate. This action aids removal of any residue of solid waste material on the surface of the plate as well as acting as an initial drying step for the plate. A further function of this air-blower is to reduce transfer of dirty water to the forward sections of the plate processor. The operating temperature of the air-blower (9) may at ambient temperature or set at about 20°C.

The plate then enters a rinsing station where, firstly, a barrier brush (10) located after the air blower section gently brushes away any debris that may be lodged in small crevices of an intricate design on the surface of the printing plate. The barrier brush and the following rinsing section, including spray bars (11), ensure that the plate is being cleaned from all surface debris. The barrier brush (10) and printing plate also cooperate together to prevent backward escape, past the brush, of rinsing fluid from the rinsing station.

The double spiral brush (12) located after the spray bars is the final station where debris is removed by the brush action, provided in a spiral manner to push debris to the sides of the rinsing section and away from the surface of the plate.

A further set of edge-rollers (13) then take up the carrier sheet and drive the plate forward to the secondary air blower (14) which is set at a working temperature of 60°C. The plate is next driven by the edge-rollers (13) in to the light treatment section (15) housing UVA and UVC light tubes, which is constructed in a cabinet style and sealed to prevent heat from the blower (14) from entering it and causing heat build-up. The cabinet also houses a number of air extractor fans located on its top-side, removing any hot air generated by the UVA and UVC tubes. The downward facing face of the cabinet is constructed from a Quartz glass panel, to allow light to pass through it, thereby irradiating the surface of the plate, to achieve the required level of 'Post-Exposure and De-tack' properties. In the light treatment section (15) the plate is simultaneously given post-exposure and de-tack exposure. At this stage, the processor is so designed that the path of the plate is at an upward angle of about 2° to ensure that any surface water on the plate path is allowed to fall back towards the rinsing and wash-out sections of the processor and not enter the electrical section housing the post-exposure and the de-tack exposure lamps.

Finally the plate is dried using a hot air drier (16) set to work at a temperature of between 40 to 60°C before it is delivered out by discharge rollers (17). The hot air drier (16) faces towards the discharge rollers (17) to stop heat entering the light treatment section (15).

As the printing plate is washed, the wash-out water is captured by the holding tank (23) and is pumped by the filtration pump (18) in to the off-board located filtration unit housing a number of cartridge type filters (20,21,22). The wash-out water is filtered and returned to the brush-head for immediate and continuous use.

The filter cartridges used may be a set of three reusable stainless steel mesh type cartridges allowing a very economical manner of debris collection in which the solid waste can be trapped and disposed of as solid material. In this example the wire mesh grading in the filter cartridges is 200 microns (20), 100 microns (21) and 70 microns (22) respectively. The polymer particles are by nature sticky and using a wire mesh type of filtration causes the solid particles to adhere to the wire mesh. A pressure valve (19) monitors the performance of the filter unit, which alerts the operator to change cartridges when the filter becomes saturated.

Alternatively, pre-wound cartridge type filters may be used (see figure 3). A bank of nine different grades of cartridges is used to achieve optimum filtration. Typically 2 x 200 micron filters (24); 2 x 100 micron filters (25); and 2 x 70 micron filters (26) are used, together with one 10 micron filter (27) and one 10 micron carbon filter (28). The last filter canister (29) is a charcoal filter, which acts as the final filtration unit enabling clear water to be discharged to drain. A three-way valve (30) allows the filters (24), (25) and (26) to be by-passed if desired. A pressure valve (19) monitors the performance of the filter unit which alerts the operator to change cartridges when the filter become saturated.

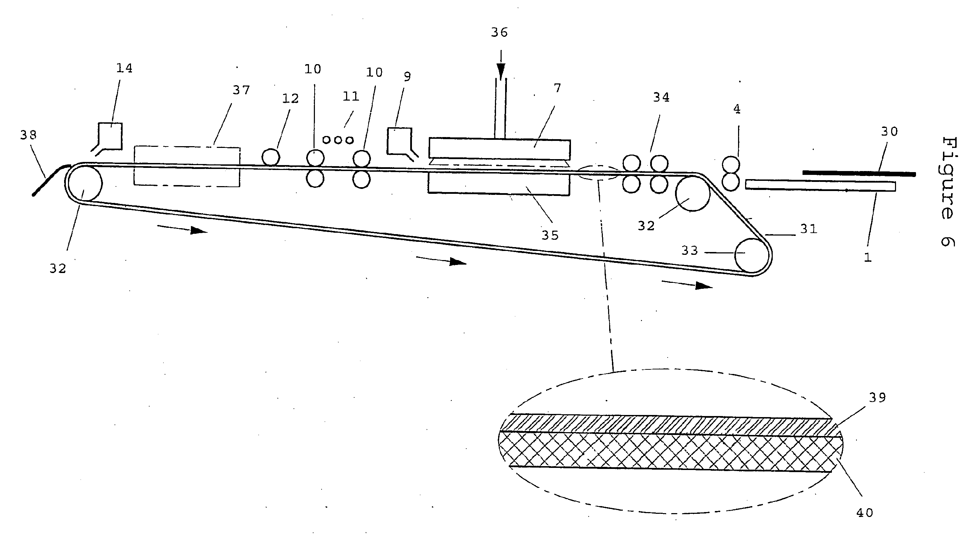

Referring to Figure 6, in an alternative embodiment of an in-line photopolymer plate processor the plate (30) is transported through the processor on the surface of a conveyor belt (31). The belt is supported by belt-supporting rollers (32 and 33), which may also drive the belt, and the upper section of the belt forms a horizontal path for the plate. This embodiment includes a belt-supporting roller at each end of the processing system (32), and a further belt-supporting roller (33) which lies below the other two rollers. Any of the belt-supporting rollers may be movable, allowing the tension of the belt to be adjusted, and allowing the belt to be removed for replacement and/or servicing. The belt includes a plate carrying layer (39) and a backing layer (40). The plate carrying layer is made of a material which interacts with the plate to keep the plate stationary relative to the belt as the plate progresses through the processor. For example, the plate carrying layer may be a material that causes the plate to adhere to the belt, having a tacky substance, for example being manufactured from a pressure sensitive adhesive plastics sheeting having a naturally sticky surface. The backing layer, which is preferably a flexible backing medium, may support the plate carrying layer. In some cases, the backing layer may be made of the same material as the plate carrying layer, in other cases, each layer may be made of a different material.

The processor also includes an in-feed table (1), in feed-rollers (4), a brush head for washing-out unexposed parts of the plate (7) (the water inflow pipe is indicated by arrow (36)), air blowers (9 and 14), a rinsing station including barrier brushes (10), spray bars (11), and a double spiral brush (12). These features perform the same function as the equivalent features of the processor shown in Figures 1 and 2. The processor also includes a pre-wetting station (34) to soften the plate prior to the washing out with the brush-head (7), a brush table (35) to support the plate on the belt during brushing by the brush-head, and a plate drying station (37) to ensure that the plate is completely dry. The plate drying station (37) may also include post exposure and detack UV lamps.

A device (38), for removing plates from the belt, is situated at the end of the processor, immediately after the end of the horizontal part of the belt. The device is preferably a rigid material, such as metal or hard plastic, and has a thin edge facing towards the processor, i.e. so that the device faces towards any oncoming plates. The device may extend laterally across so that it is the same width or substantially the same width as a plate. Preferably the device extends laterally so that the width of the device can support a plate. In use, as a plate approaches the device, the belt motion of the belt pushes the leading edge of the plate onto the device, and then continues to push the plate so that it slides over the surface of the device and ultimately, off the belt. The plate may then come to rest on the device, or the device may be angled downwards so that the plate slides down the device and comes to rest of a tray or other delivery surface.

In use, a plate is placed on the in-feed table, for example by the operator, and is driven onto the belt by the action of the in-feed roller. The belt provides a moving, substantially horizontal, surface which transports the plate through the processor, allowing the plate to be processed by the processor. The edge-roller transportation system of the processor shown in Figures 1 to 5 may be replaced with the belt transportation system of Figure 6.

### Example 1

The benefit of using edge rollers instead of complete rollers is described in more detail below.

A number of photopolymer plates were washed out after exposure to UV light in the manner as described above, using an in-line processor as shown in Figures 1 and 2. The exposed photopolymer plate was processed in the in-line equipment according to each test as numbered below, thereby building up a quantity of suspended solid particles in the wash-out water held in the holding tank.

The purpose of these tests was to assess the quantity of scum deposited on the surface of the printing plate when the plate processor was fitted with fully covered rubber rollers compared to when only edge-rollers were used.

**Table 1**

| Test No. | Polymer Quantity in Water (kg) | Catchment Tray Capacity (L) | Scum on Rollers (g./cm²) | Scum on Plate (g./cm²) | Scum on plate (when using edge rollers) |
|---|---|---|---|---|---|
| 1 | 5 | 40 | 1.9 | 1.2 | |
| 2 | 5 | 40 | --- | --- | 0 |
| 3 | 10 | 40 | 5 | 1.7 | |
| 4 | 10 | 40 | --- | --- | 0 |
| 5 | 15 | 40 | 2.3 | 1.9 | |
| 6 | 15 | 40 | --- | --- | 0 |

In Table 1, test numbers 1, 3, and 5 correspond to the use of fully covered rubber rollers, and test numbers 2, 4, and 6 correspond to the use of edge-rollers.

As can be seen from Table 1, any polymer debris located on the surface of the printing plate was easily removed by the combined actions of the barrier brush and the double spiral brush. This action was effective even when the catchment tray was heavily concentrated with polymer debris.

It is to be understood that variants of the above described embodiments of the invention in its various aspects, such as would be readily apparent to the skilled person, may be made without departing from the scope of the invention in any of its aspects.

## Claims

1. A method for feeding a photopolymerised elastomeric printing plate, subsequent to exposure and washing out thereof, along a path through a rinsing station, which method comprises:
optionally providing a plate assembly comprising the plate and, supporting the plate, a carrier having a pair of opposed peripheral regions each extending laterally beyond respective opposed lateral edge regions of the plate,
providing, transversely of the path, at least one pair of driven rollers (8, 13) defining a nip therebetween through which the plate can pass so as to be forwarded along the path by frictional engagement of the plate or plate assembly with each of the driven rollers within the nip, at least one of which rollers is profiled so as
(a) to allow contact of the profiled roller with the opposed lateral edge regions of the plate or, when provided, corresponding opposed peripheral regions of the plate assembly, thereby to allow the said frictional engagement, but
(b) to allow freedom from contact of the plate with the or each profiled roller at an interior region of the plate between the said regions in contact with the or each profiled roller, and
feeding the plate, or optionally when provided, the plate assembly, by the driven rollers along the path through the rinsing station.

2. A method according to claim 1, wherein at least the roller adjacent to the printing surface of the plate is a profiled roller.

3. A method according to claim 2, wherein the profiled roller is profiled so as to allow freedom from contact of the plate with the profiled roller throughout the printing area of the plate.

4. A method according to any one of claims 1 to 3, wherein the profiled roller
comprises a middle portion located between each of a pair of end portions on the longitudinal axis such that each end portion contacts the plate and/or carrier and the middle portion does not contact the plate.

5. A method according to claim 4, wherein the pair of end portions, defining respective contact regions, one at each of opposed longitudinal ends of the profiled roller, have a radial cross-section larger than that of any part of the middle portion axially between the contact regions.

6. A method according to claim 5, wherein each end portion is of a substantially circular radial cross section.

7. Apparatus for feeding a photopolymerised elastomeric printing plate, subsequent to exposure and washing out thereof, along a path through a rinsing station, which apparatus comprises:
a rinsing station for rinsing the plate,
at least one pair of drivable rollers (8, 13) defining a nip therebetween through which the plate can pass to allow the plate to be forwarded along the path by frictional engagement of the plate, or of a plate assembly including the plate, with each of the rollers within the nip, wherein the plate assembly, when provided, comprises the plate and, supporting the plate, a carrier having a pair of opposed peripheral regions, each extending laterally beyond respective opposed lateral edge regions of the plate,
and wherein at least one of which rollers is profiled so as
(a) to allow contact of the profiled roller with the opposed lateral edge regions of the plate, or, when provided, corresponding opposed peripheral regions of the plate assembly, thereby to allow the said frictional engagement, but
(b) to allow freedom from contact of the plate with the or each profiled roller at an interior region of the plate between the said regions in contact with the or each profiled roller.

8. Apparatus according to claim 7, wherein the profiled roller is as defined in any one of claims 3 to 6.

9. Apparatus according to claim 7 or claim 8, additionally comprising apparatus for rinsing a photopolymerised elastomeric printing plate, subsequent to exposure and washing out thereof, while travelling along a path through a rinsing station, which apparatus comprises:
a rotary brush (12), which brush has a longitudinal axis extending transversely across the plate, and which brush, on rotation about its longitudinal axis, sweeps a substantially cylindrical path of rotation,
and wherein the brush is so constructed that on contact thereof with the plate, the rotation of the brush causes any debris on the printing surface of the plate to move away from the printing surface towards a peripheral region of the plate.

10. Apparatus according to claim 9, wherein the brush is so constructed that on ontact thereof with the plate, the rotation of the brush causes any debris on the printing surface of the plate to move away from the printing surface towards a peripheral region of the plate.

11. Apparatus according to any one of claims 7 to 9, wherein the apparatus further comprises means for inclining the plate after contacting the plate with rinsing fluid, such that any rinsing fluid on the printing surface of the plate is allowed by gravity to run off the printing surface in a direction towards the rinsing station.

12. Apparatus according to any one of claims 7 to 11, wherein the apparatus further comprises any one or more of:
a. a pair of driven rollers (8) for feeding the plate into the rinsing station;
b. an air blower (9) for dispersing any wash-out fluid on the plate before contacting the plate with rinsing fluid;
c. a rotary brush (10) for brushing the plate before contacting the plate with rinsing fluid;
d. spray bars (11) for contacting the plate with rinsing fluid;
e. a rotary brush (12) for brushing the plate after contacting the plate with rinsing fluid;
f. a pair of driven rollers (13) for feeding the plate out of the rinsing station; and/or
g. an air blower (14) for initial drying of the plate after the plate has been rinsed.

13. Apparatus according to claim 12, wherein the rotary brush (10) of (c) provides a barrier preventing any substantial escape of rinsing fluid backwardly out of the rinsing station.

14. Apparatus for processing a pre-exposed photopolymerised elastomeric printing plate, which apparatus comprises:
apparatus for washing out the plate comprising a source of wash-out fluid, means for supplying fluid from the source of wash-out fluid to a plate positioned in the apparatus, means for allowing fluid to flow to a filtration unit after contact with the plate, and a filtration unit, wherein the filtration unit houses a wire sieve such that wash-out fluid flowing through the filtration unit flows through the sieve; and
apparatus according to any one of claims 7 to 13.

15. Apparatus according to any one of claims 7 to 14, wherein the apparatus further comprises:
a. a combined brush and water spray adapted to soften the plate prior to a wash out brushing operation;
b. a source of clean and/or filtered wash-out fluid;
c. a wash-out brush having a wash-out brush head with downwardly directed bristles; and/or
d. a spray bar situated in the vicinity of downwardly directed bristles, and adapted to direct wash-out fluid downwardly along the bristles to the plate.

## Patentansprüche

1. Verfahren zum Zuführen einer photopolymerisierten Elastomerdruckplatte entlang einer Bahn durch eine Spülstation nach Belichtung und Auswaschen derselben, wobei das Verfahren Folgendes umfasst:
gegebenenfalls Bereitstellen einer Plattenbauanordnung, welche die Platte und ein Trageelement zur Auflage der Platte mit einem Paar entgegengesetzter Peripheriebereiche, die sich jeweils seitlich über die jeweiligen entgegengesetzten seitlichen Randbereiche der Platte hinaus erstrecken, umfasst,
Bereitstellen zumindest eines angetriebenen Walzen paars (8, 13) quer verlaufend zur Bahn, die einen Spalt zwischen den Walzen definieren, durch den die Platte geführt werden kann, sodass sie entlang der Bahn mittels Reibeeingriff der Platte oder der Plattenbauanordnung mit jeder der angetriebenen Walzen im Walzenspalt vorgetrieben werden kann, wobei zumindest eine der Walzen so profiliert ist, um
(a) Kontakt der Profilwalze mit den entgegengesetzten seitlichen Randbereichen der Platte oder, falls bereitgestellt, mit den entsprechenden entgegengesetzten Peripheriebereichen der Plattenbauanordnung ermöglicht, um **dadurch** den Reibeeingriff zu ermöglichen, jedoch auch
(b) um Kontaktfreiheit der Platte mit der oder mit jeder Profilwalze an einem Innenbereich der Platte zwischen den Bereichen, die mit der oder mit jeder Profilwalze in Kontakt sind, zu ermöglichen und
Zuführen der Platte oder gegebenenfalls, falls bereitgestellt, der Plattenbauanordnung durch die angetriebenen Walzen entlang der Bahn durch die Spülstation.

2. Verfahren nach Anspruch 1, worin zumindest die zur Druckoberfläche der Platte benachbarte Walze eine Profilwalze ist.

3. Verfahren nach Anspruch 2, worin die Profilwalze so profiliert ist, dass sie Kontaktfreiheit der Platte mit der Profilwalze im gesamten Druckbereich der Platte ermöglicht.

4. Verfahren nach einem der Ansprüche 1 bis 3, worin die Profilwalze einen Mittelteil umfasst, der sich zwischen jedem Paar von Endteilen auf der Längsachse befindet, sodass jeder Endteil die Platte und/oder das Trageelement berührt und der Mittelteil die Platte nicht berührt.

5. Verfahren nach Anspruch 4, worin das Paar von Endteilen, die entsprechende Kontaktbereiche, einen an jedem entgegengesetzten Längsende der Profilwalze, definieren, einen radialen Querschnitt aufweist, der größer ist, als der von jedem Teil des Mittelteils, der axial zwischen den Kontaktbereichen liegt.

6. Verfahren nach Anspruch 5, worin jeder Endteil von einem im Wesentlichen kreisförmigen radialen Querschnitt stammt.

7. Vorrichtung zum Zuführen einer photopolymerisierten Elastomerdruckplatte entlang einer Bahn durch eine Spülstation nach Belichtung und Auswaschen derselben, wobei die Vorrichtung Folgendes umfasst:
eine Spülstation zum Spülen der Platte,
zumindest ein antreibbares Walzenpaar (8, 13), die einen Spalt zwischen den Walzen definieren, durch den die Platte geführt werden kann, sodass die Platte entlang der Bahn mittels Reibeeingriff der Platte oder der Plattenbauanordnung einschließlich der Platte mit jeder der Walzen innerhalb des Spalts weitergeleitet werden kann, worin die Plattenbauanordnung, falls bereitgestellt, die Platte und zur Auflage der Platte ein Trageelement mit einem Paar entgegengesetzter Peripheriebereiche umfasst, wobei sich jeder Peripheriebereich seitlich über jeweilige entgegengesetzte seitliche Randbereiche der Platte erstreckt,
und worin zumindest eine der Walzen so profiliert ist, um
(a) Kontakt der Profilwalze mit den entgegengesetzten seitlichen Randbereichen der Platte oder, falls bereitgestellt, mit den entsprechenden entgegengesetzten Peripheriebereichen der Plattenbauanordnung zu ermöglichen, um **dadurch** den Reibeeingriff zu ermöglichen, jedoch auch
(b) um Kontaktfreiheit der Platte mit der oder mit jeder Profilwalze im Innenbereich der Platte zwischen den Bereichen, die mit der oder mit jeder Profilwalze in Kontakt sind, zu ermöglichen.

8. Vorrichtung nach Anspruch 7, worin die Profilwalze so ist, wie in einem der Ansprüche 3 bis 6 definiert.

9. Vorrichtung nach Anspruch 7 oder Anspruch 8, wobei die Vorrichtung zusätzlich eine Vorrichtung zum Spülen einer photopolymerisierten Elastomerdruckplatte während des Weiterleitens entlang einer Bahn durch eine Spülstation nach Belichtung und Auswaschen derselben umfasst, wobei die Vorrichtung Folgendes umfasst:
eine rotierende Bürste (12), wobei die Bürste eine sich quer über die Platte erstreckende Längsachse aufweist und wobei die Bürste bei Rotation um ihre Längsachse einen im Wesentlichen zylindrischen Rotationsweg überstreicht,
und worin die Bürste so konstruiert ist, dass aufgrund der Bürstenrotation beim Kontakt der Bürste mit der Platte Verunreinigungen auf der Druckoberfläche der Platte von der Druckoberfläche zu einem Peripheriebereich der Platte bewegt werden.

10. Vorrichtung nach Anspruch 9, worin die Bürste so konstruiert ist, dass aufgrund der Bürstenrotation beim Kontakt der Bürste mit der Platte alle Verunreinigungen auf der Druckoberfläche der Platte von der Druckoberfläche zu einem Peripheriebereich der Platte bewegt werden.

11. Vorrichtung nach einem der Ansprüche 7 bis 9, worin die Vorrichtung im Weiteren Mittel zum Neigen der Platte nach Aufbringen der Spülflüssigkeit auf die Platte umfasst, sodass es ermöglicht wird, dass die gesamte Spülflüssigkeit auf der Druckoberfläche der Platte aufgrund der Schwerkraft von der Oberfläche in Richtung der Spülstation abrinnt.

12. Vorrichtung nach einem der Ansprüche 7 bis 11, worin die Vorrichtung im Weiteren eine beliebige oder mehrere der folgenden Komponenten umfasst:
a. ein angetriebenes Walzenpaar (8) zum Zuführen der Platte in die Spülstation
b. ein Luftgebläse (9) zum Verteilen der Auswaschflüssigkeit auf der Platte vor dem Aufbringen der Spülflüssigkeit auf die Platte;
c. eine rotierende Bürste (10) zum Bürsten der Platte vor dem Aufbringen der Spülflüssigkeit auf die Platte;
d. Sprühbalken (11) zum Aufbringen der Spülflüssigkeit auf die Platte;
e. eine rotierende Bürste (12) zum Bürsten der Platte nach dem Aufbringen der Spülflüssigkeit auf die Platte,
f. ein angetriebenes Walzenpaar (13) zur Ausgabe der Platte aus der Spülstation; und/oder
g. ein Luftgebläse (14) zum erstmaligen Trocknen der Platte nach dem Spülen der Platte.

13. Vorrichtung nach Anspruch 12, worin die rotierende Bürste (10) von (c) ein Hindernis zur Verhinderung eines wesentlichen Austrittes der Spülflüssigkeit aus der Spülstation bereitstellt.

14. Vorrichtung zum Bearbeiten einer zuvor belichteten photopolymerisierten Elastomerdruckplatte, wobei die Vorrichtung Folgendes umfasst:
Vorrichtung zum Auswaschen der Platte, die eine Quelle der Auswaschflüssigkeit, Mittel zum Zuführen von Flüssigkeit aus der Quelle der Auswaschflüssigkeit zu einer Platte, die in der Vorrichtung liegt, Mittel, die es der Flüssigkeit ermöglichen, nach Aufbringen der Flüssigkeit auf die Platte zu einer Filtrationseinheit zu fließen, und eine Filtrationseinheit, worin die Filtrationseinheit ein Drahtsieb enthält, sodass die Auswaschflüssigkeit, die durch die Filtrationseinheit fließt, durch das Sieb fließt; und
eine Vorrichtung nach einem der Ansprüche 7 bis 13.

15. Vorrichtung nach einem der Ansprüche 7 bis 14, worin die Vorrichtung im Weiteren Folgendes umfasst:
a. einen kombinierten Bürsten- und Wassersprüher, der so ausgebildet ist, dass er die Platte vor dem Bürstvorgang während des Auswaschens weicher macht;
b. eine Quelle von reiner und/oder filtrierter Auswaschflüssigkeit;
c. eine Auswaschbürste mit einem Auswaschbürstkopf mit nach unten ausgerichteten Borsten; und/oder
d. einen Sprühbalken, der im Nahbereich der nach unten ausgerichteten Borsten liegt und so ausgebildet ist, dass er die Auswaschflüssigkeit entlang der Borsten nach unten auf die Platte lenkt.

## Revendications

1. Procédé d'amenée d'une plaque d'impression photopolymérisée, à la suite d'une exposition et du lavage de celle-ci, le long d'un chemin à travers une station de rinçage, ledit procédé comprend:
réaliser en option un ensemble de plaque comprenant la plaque et, supportant la plaque, un support ayant une paire de régions périphériques opposées, chacune s'étendant latéralement au-delà des régions de bord latéral respectives opposées de la plaque,
réaliser, transversalement du chemin, au moins une paire de rouleaux menés (8, 13) définissant un pincement entre eux à travers lequel la plaque peut passer de manière à être convoyée vers l'avant le long d'un chemin par une prise de friction de la plaque ou de l'ensemble de plaque avec chacun des rouleaux menés dans le pincement, au moins un des rouleaux étant profilé pour
(a) permettre le contact du rouleau profilé avec les régions de bord latéral opposées de la plaque ou bien, lorsqu'elles sont prévues, des régions périphériques opposées correspondantes de l'ensemble de plaque pour permettre ainsi ladite prise de friction, mais
(b) pour permettre une libération du contact de la plaque avec le ou chaque rouleau profilé à une région intérieure de la plaque entre lesdites régions en contact avec le ou chaque rouleau profilé, et
amener la plaque, ou en option lorsqu'il est réalisé, l'ensemble de plaque, par les rouleaux menés le long du chemin à travers la station de rinçage.

2. Procédé selon la revendication 1, dans lequel au moins le rouleau adjacent à la surface d'impression de la plaque est un rouleau profilé.

3. Procédé selon la revendication 2, dans lequel le rouleau profilé est profilé de manière à donner une liberté de contact de la plaque avec le rouleau profilé à travers la zone d'impression de la plaque.

4. Procédé selon l'une quelconque des revendications 1 à 3, dans lequel le rouleau profilé comprend une portion médiane située entre chacune d'une paire de portions d'extrémité sur l'axe longitudinal de sorte que chaque portion d'extrémité vient en contact avec la plaque et/ou le support, et la portion médiane ne vient pas en contact avec la plaque.

5. Procédé selon la revendication 4, dans lequel la paire de portions d'extrémité, définissant des régions de contact respectives, une à chacune d'extrémités longitudinales opposées du rouleau profilé, ont une section transversale radiale plus grande que celle de n'importe quelle partie de la portion médiane axialement entre les régions de contact.

6. Procédé selon la revendication 5, dans lequel chaque portion d'extrémité est une section transversale radiale sensiblement circulaire.

7. Appareil d'amenée d'une plaque d'impression élastomère photopolymérisée, à la suite d'une exposition et du lavage de celle-ci, le long d'un chemin à travers une station de rinçage, ledit appareil comprend:
une station de rinçage pour rincer la plaque,
au moins une paire de rouleaux menés (8, 13) définissant un pincement entre eux à travers lequel la plaque peut passer pour permettre que la plaque soit convoyée vers l'avant le long du chemin par une prise de friction de la plaque ou d'un ensemble de plaque incluant la plaque, avec chacun des rouleaux dans le pincement, où l'ensemble de plaque, lorsqu'il est réalisé, comprend la plaque et, supportant la plaque, un support ayant une paire de régions périphériques opposées, chacune s'étendant latéralement au-delà des régions de bord latéral respectives opposées de la plaque,
et où au moins un desdits rouleaux est profilé pour
a. permettre le contact du rouleau profilé avec les régions de bord latéral opposées de la plaque ou, lorsqu'elles sont réalisées, les régions périphériques correspondantes opposées de l'ensemble de plaque, en permettant ainsi ladite prise de friction, mais
b. pour donner une liberté de contact de la plaque avec le ou chaque rouleau profilé à une région intérieure de la plaque entre lesdites régions en contact avec le ou chaque rouleau profilé.

8. Appareil selon la revendication 7, dans lequel le rouleau profilé est tel que défini dans l'une quelconque des revendications 3 à 6.

9. Appareil selon la revendication 7 ou la revendication 8, comprenant additionnellement un appareil pour le rinçage d'une plaque d'impression élastomère photopolymérisée, à la suite d'une exposition et du lavage de celle-ci, tout en se déplaçant le long d'un chemin à travers une station de rinçage, ledit appareil comprend:
une brosse rotative (12), ladite brosse possède un axe longitudinal s'étendant transversalement sur la plaque, et ladite brosse, lors de la rotation autour de son axe longitudinal, balaye un chemin de rotation sensiblement cylindrique,
et où la brosse est construite de façon que lors du contact de celle-ci avec la plaque, la rotation de la brosse amène tous les débris sur la surface d'impression de la plaque à s'éloigner de la surface d'impression vers une région périphérique de la plaque.

10. Appareil selon la revendication 9, dans lequel la brosse est construite de façon que lors du contact de celle-ci avec la plaque, la rotation de la brosse amène tous les débris sur la surface d'impression de la plaque à s'éloigner de la surface d'impression vers une région périphérique de la plaque.

11. Appareil selon l'une quelconque des revendications 7 à 9, dans lequel l'appareil comprend en outre des moyens pour incliner la plaque après la mise en contact de la plaque avec un fluide de rinçage de sorte que tout fluide de rinçage sur la surface d'impression de la plaque peut s'écouler par gravité de la surface d'impression dans une direction vers la station de rinçage.

12. Appareil selon l'une quelconque des revendications 7 à 11, où l'appareil comprend en outre un ou plusieurs de:
a. une paire de rouleaux menés (8) pour l'amenée de la plaque dans la station de rinçage;
b. une soufflante d'air (9) pour disperser tout fluide de lavage sur la plaque avant la mise en contact de la plaque avec le fluide de rinçage;
c. une brosse rotative (10) pour brosser la plaque avant la mise en contact de la plaque avec le fluide de rinçage;
d. des barres de projection (11) pour mettre en contact la plaque avec le fluide de rinçage;
e. une brosse rotative (12) pour brosser la plaque après la mise en contact de la plaque avec le fluide de rinçage;
f. une paire de rouleaux menés (13) pour l'amenée de la plaque hors de la station de rinçage; et/ou
g. une soufflante d'air (14) pour le séchage initial de la plaque après que la plaque a été rincée.

13. Appareil selon la revendication 12, dans lequel la brosse rotative (10) de (c) constitue une barrière empêchant tout échappement substantiel du fluide de rinçage vers l'arrière de la station de rinçage.

14. Appareil pour le traitement d'une plaque d'impression élastomère photopolymérisée pré-exposée, ledit appareil comprend:
un appareil pour laver la plaque comprenant une source de fluide de lavage, des moyens pour fournir du fluide de la source du fluide de lavage à une plaque positionnée dans l'appareil, des moyens pour permettre au fluide de s'écouler vers une unité de filtration après le contact avec la plaque, et une unité de filtration, où l'unité de filtration renferme un tamis en maille de façon que le fluide de lavage s'écoulant à travers l'unité de filtration s'écoule à travers le tamis; et
l'appareil selon l'une quelconque des revendications 7 à 13.

15. Appareil selon l'une quelconque des revendications 7 à 14, où l'appareil comprend en outre:
a. une brosse et projection d'eau combinées conçue pour ramollir la plaque avant une opération de lavage brossage;
b. une source de fluide de lavage propre et/ou filtré;
c. une brosse de lavage ayant une tête de brosse de lavage avec des poils dirigés vers le bas; et/ou
d. une barre de projection située au voisinage des poils dirigés vers le bas et conçue pour diriger le fluide de lavage vers le bas le long des poils à la plaque.
